# EUROPÄISCHE PATENTSCHRIFT

(11) **EP 0 313 162 B1**
(45) Veröffentlichungstag und Bekanntmachung des Hinweises auf die Patenterteilung: **10.03.1993**
(21) Anmeldenummer: 88202321.1
(22) Anmeldetag: 18.10.1988
(51) Int. Cl.: G01S 17/02, G01S 7/48, H03K 17/94, E05D 5/10, G01R 31/36, E03D 5/10, F16K 37/00

(54) **Anordnung zur Steuerung und Fernsteuerung eines bei Annäherung bzw. Weggang eines Benutzers ein- bzw. abschaltbaren, batteriebetriebenen Gerätes**
Control and remote control of a switchable battery-fed device by the approach to or the departure from the vicinity by a user
Procédé de commande et de télécommande d'un appareil commutable avec alimentation à piles, mis en- ou hors-fonction par l'approche ou l'éloignement d'un utilisateur

(30) Priorität: 23.10.1987 DE 3735854
(43) Veröffentlichungstag der Anmeldung: 26.04.1989
(73) Patentinhaber: Philips Patentverwaltung GmbH, 22335 Hamburg (DE); Philips Electronics N.V., 5621 BA Eindhoven (NL)
(72) Erfinder: Lange, Jürgen, D-2000 Hamburg 62 (DE); von Vignau, Ralph, D-2000 Hamburg 53 (DE)
(74) Vertreter: Poddig, Dieter, Dipl.-Ing.

(56) Entgegenhaltungen:
- US-A- 4 324 251
- PATENT ABSATRACTS OF JAPAN, Band 006, Nr. 106, Gruppe M-213, 10. Mai 1983; & JP-A-58 28 076 (MATSUSHITA)

## Beschreibung

Die Erfindung bezieht sich auf eine Anordnung zur Steuerung und Fernsteuerung eines bei Annäherung bzw. Weggang eines Benutzers ein- bzw. abschaltbaren batteriebetriebenen Gerätes, insbesondere einer Wasserspülung, mit einem bei Annäherung des Benutzers in Betrieb setzbaren elektrischen Stellglied,
einer Steuerschaltung, die einen Infrarotsender zur Aussendung von Detektionsimpulsen ansteuert und die nach Empfang der von einem Benutzer reflektierten Detektionsimpulse in einem Infrarotempfänger das Stellglied zur Einschaltung vorbereit, und
einer Testeinheit zur Messung des Ladungszustandes der Batterie.

Aus dem Prospekt "FLUSHTRONIC, Die erste elektronische Urinalspülung ohne Stromanschluß" der Firma KERAMAG ist die eingangs genannte Anordnung bekannt. Hierbei werden von einem Infrarotsender Infrarot-Detektionsimpulse in bestimmten Intervallen ausgesendet. Reflektiert ein Benutzer der Urinalspülung die Detektionsimpulse, werden diese von dem Infrarotempfänger empfangen und einer Steuerschaltung, z.B. einen Mikroprozessor, verarbeitet. Die Steuerschaltung bereitet dann einen Spülvorgang vor. Hierzu wird ein Stellglied, d.h. ein Ventil, bei Einleitung des Spülvorganges geöffnet. Bei Annäherung des Benutzers verkürzen sich die Aussendeintervalle der Detektionsimpulse. Die Steuerschaltung überprüft mit Hilfe einer Testeinheit den Ladungszustand der Batterie. Ist der Ladungszustand unter einen bestimmten Wert gesunken, wird das durch eine optische Einrichtung an dem Gerät angezeigt. Da der schwache Ladungszustand der Batterie dauernd optisch angezeigt wird und eine optische Einrichtung, z.B. eine Leuchtdiode, einen sehr viel höheren Energieverbrauch hat als ein Mikroprozessor, wird die Batterie zusätzlich belastet und entlädt sich schneller. Wird zur Öffnung des Ventils am Wasserzufluß ein Motor verwendet, so kann bei zu spätem Wechsel der Batterie das Ventil geöffnet bleiben, weil der Motor nicht genügend Energie von der Batterie erhält.

Der Erfindung liegt daher die Aufgabe zugrunde, eine Anordnung zur Steuerung und Fernsteuerung eines bei Annäherung bzw. Weggang eines Benutzers ein- bzw. abschaltbaren, batteriebetriebenen Gerätes zu schaffen, die sicherstellt, daß das Stellglied nach Einschaltung wieder abschaltbar ist, und die den Ladungszustand der Batterie anzeigt, ohne daß eine wesentliche zusätzliche Belastung auftritt.

Diese Aufgabe wird bei einer Anordnung der eingangs genannten Art dadurch gelöst, daß nach Empfang der reflektierten Detektionsimpulse die Steuerschaltung
- die Testeinheit über den gemessenen Ladungszustand der Batterie abfragt,
- das Stellglied nur dann zur Einschaltung vorbereitet, wenn die Batterie einen solchen Ladungszustand aufweist, daß das Stellglied wieder abschaltbar ist und
- den Infrarotsender anschließend veranlaßt, anstatt der Detektionsimpulse Statusimpulse auszusenden, welche eine Information über den Ladungszustand der Batterie enthalten und von einer zusätzlichen Infrarot-Empfangseinheit empfangbar sind, die eine Auswerteschaltung zur Auswertung der Statusimpulse und eine Anzeigevorrichtung zur Anzeige des Ladungszustandes der Batterie enthält.

Bei der erfindungsgemäßen Anordnung fragt nach Annäherung eines Benutzers und Reflexion der Detektionsimpulse die Steuerschaltung den gemessenen Ladungszustand der Batterie ab. Die Messung des Ladungszustandes kann hierbei jederzeit oder nur bei der Abfragung vorgenommen werden. Weist die Batterie einen solchen Ladungszustand auf, daß das Stellglied nach der Einschaltung wieder abgeschaltet werden kann, wird die Einschaltung vorbereitet. Eine solche Vorbereitung kann z.B. für eine Urinalwasserspülung bedeuten, daß nach einer bestimmten Wartezeit ein Ventil (Stellglied) geöffnet wird. Nach der Abfragung über den Ladungszustand werden die Detektionsimpulse durch Statusimpulse ersetzt, die eine Information über den Ladungszustand der Batterie enthalten. Beispielsweise können drei verschiedene Angaben ausgegeben werden, die aussagen, daß die Ladung der Batterie genügend hoch, schwach oder sehr gering ist. Die Information über den Ladungszustand kann mittels einer Infrarot-Empfangseinheit (Fernbedienung) ausgewertet werden. Ein Bediener stellt sich dann vor das Gerät und überprüft, ob es notwendig ist, die Batterie auszuwechseln. Der Ladungszustand wird nach der Auswertung in der Empfangseinheit angezeigt. Nach Weggang des Benutzers werden wieder Detektionsimpulse ausgegeben.

Vielfach sind solche Geräte an einem Ort mehrfach vorhanden. Jedes Gerät kann dann mit einer Empfangseinheit überprüft werden. Daher benötigt ein Gerät keine zusätzliche Anzeigeeinheit für den Ladungszustand. Bei einem schwachen Ladungszustand der Batterie tritt außerdem keine zusätzliche wesentliche Belastung der Batterie auf.

Das Gerät kann nicht nur als Wasserspülung, sondern beispielsweise auch zur Steuerung von Lampen, die eingeschaltet werden sollen, wenn jemand sich den Lampen nähert, oder zur Steuerung eines Türöffners bei Annäherung einer Person verwendet werden.

In einer Weiterbildung der Erfindung ist vorgesehen, daß nach Empfang der reflektierten Detektionsimpulse eine Prüfeinheit den Zustand des Stellgliedes bei Abfragung der Steuerschaltung meldet und daß die Steuerschaltung den Statusimpulsen eine Zusatzinformation über den Zustand des Stellglieds dazugibt. Bei dieser Weiterbildung wird eine Überprüfung der Funktionsfähigkeit des Stellgliedes vorgenommen. Die Zustandsinformation über das Stellglied wird nach der Überprüfung in die Statusimpulse gesetzt. So kann bei einer defekten Vorrichtung von einem Bediener mittels der Empfangseinheit festgestellt werden, in der diese Information ausgewertet wird, ob dieser Defekt vom Stellglied herrührt.

Ein Gerät kann so ausgebildet sein, daß es als Handspülung oder Urinalspülung dient. Beide Spülarten erfordern eine unterschiedliche Steuerung des Wasserzulaufventils. Es ist daher vorgesehen, daß nach Empfang von Infrarot-Steuerimpulsen, die von einer zur Programmierung dienenden Infrarot-Sendereinheit ausgegeben werden, die Steuerschaltung
- den Infrarotsender veranlaßt, keine Detektions- oder Statusimpulse auszusenden und
- einen Speicher aufruft, in welchen die in den Steuerimpulsen vorhandene Information zur Steuerung des Stellgliedes bei Inbetriebnahme abgelegt wird.

Bei Inbetriebnahme des Gerätes wird also mittels der Sendereinheit (Fernbedienung), die zur Steuerung des Stellgliedes erforderlichen Vorgänge eingegeben und gespeichert. Die erforderliche Information ist in Steuersignalen enthalten, die von dem Gerät empfangen, ausgewertet und gespeichert werden. Das Gerät verhindert dabei, daß Detektions- oder Statusimpulse ausgesendet werden.

Nach der Installation des Gerätes ist es erforderlich, daß eine Entfernungseinstellung vorgenommen wird, d.h. der Abstand eingestellt wird, bei dem sichergestellt ist, daß reflektierte Impulse den Empfänger erreichen. Hierzu ist vorgesehen, daß nach Empfang von Infrarot-Einstellimpulsen, die von der Infrarot-Sendereinheit ausgegeben werden, die Steuerschaltung
- den Infrarotsender veranlaßt, Infrarot-Testimpulse auszusenden, welche ein vor dem Infrarotsender und -empfänger angeordneter Reflektor reflektiert, und
- durch Bestimmung der Stärke der reflektierten Testimpulse eine Einstellung der Leistung des Infrarotsenders und/oder Infrarotempfängers mittels einer Ansteuerschaltung vornimmt.

Die Sendereinheit und die Empfängereinheit brauchen nicht getrennt aufgebaut werden, sondern können als eine Einheit realisiert werden.

Ein Ausführungsbeispiel der Erfindung wird nachstehend anhand der Zeichnungen näher erläutert. Es zeigen:
Fig. 1 eine Anordnung mit einer batteriebetriebenen Geräteeinheit und eine Sender- und Empfangseinheit und
Fig. 2 ein Blockdiagramm zur Erläuterung des Steuerablaufes in der Anordnung nach Fig. 1.

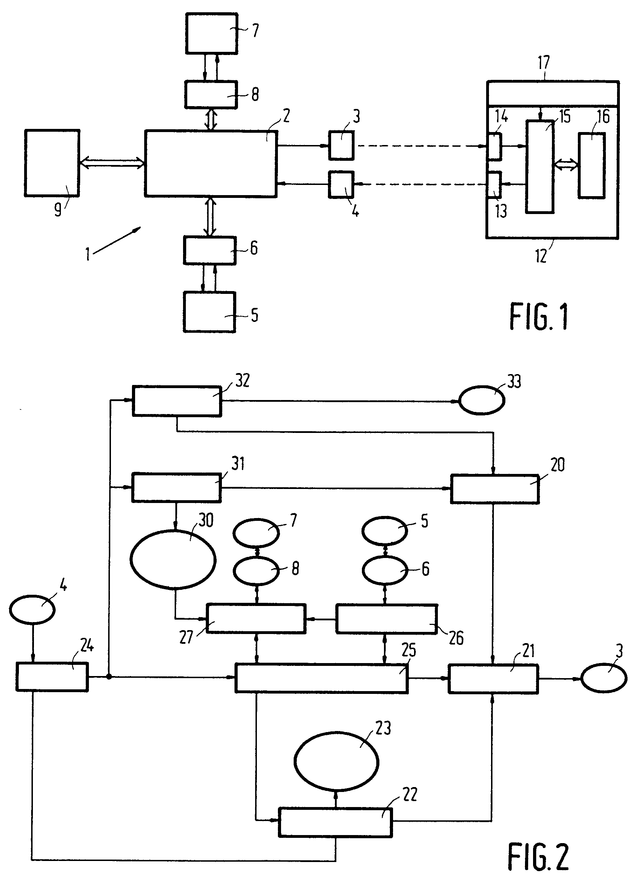

In Fig. 1 ist ein Gerät 1 als Wasserspülung, z.B. zum Händewaschen, dargestellt, die bei Annäherung eines Benutzers einen Spülvorgang einleitet. Die Annäherung eines Benutzers wird von einer Steuerschaltung 2, z.B. einem Mikroprozessor, mit Hilfe eines Infrarotsenders 3 und eines Infrarotempfängers 4 detektiert. Der Infrarotsender 3 sendet in bestimmmten Intervallen, z.B. alle zwei Sekunden, Infrarot-Detektionsimpule aus, die von dem Benutzer reflektiert werden und vom Infrarot-Empfänger 4 empfangen werden. Solche Detektionsimpulse können beispielsweise aus drei Impulsen gleicher Dauer bestehen. Die Steuerschaltung prüft nach Empfang der Detektionsimpulse die Batterie 5, die zur Energieversorgung des Gerätes 1 dient, mittels einer Batterietesteinheit 6. Ist der Ladungszustand der Batterie 5 ausreichend, wird ein elektrisches Stellglied 7, z.B. ein Motor, nachdem dessen Funktionsfähigkeit getestet worden ist, betätigt. Der Motor öffnet ein Ventil im Wasserzulauf, so daß der Spülvorgang eingeleitet werden kann. Zur Steuerung des elektrischen Stellgliedes 7 dient eine Prüf- und Ansteuereinheit 8, die zwischen dem Stellglied 7 und der Steuerschaltung 2 angeordnet ist. Die Steuerschaltung 2 ist des weiteren mit einem Speicher 9 gekoppelt, der beispielsweise Steuerbefehle für die Steuerung des Stellgliedes 7 enthält, und die von der Steuerschaltung 2 abgerufen werden.

Nachdem die Steuerschaltung 2 den Test der Batterie 5 und des Stellgliedes 7 durchgeführt hat, werden in periodischen Intervallen anstatt der Detektionsimpulse Statusimpulse von der Steuerschaltung 2 erzeugt, die von dem Infrarotsender 3 gesendet werden und die eine Information über den Ladungszustand der Batterie 5 und den Funktionszustand des Stellgliedes 7 enthalten. Diese Statusimpulse können von einer Sender- und Empfangseinheit 12 (Fernbedienung) empfangen, ausgewertet und angezeigt werden. Die Einheit 12 enthält ebenfalls einen Infrarotsender 13 und einen Infrarotempfänger 14. Die empfangenen Infrarotimpulse werden als elektrische Impulse einer Auswerte- und Steuerschaltung 15 zugeführt, die nach Auswertung eine Anzeige 16 veranlaßt, z.B. den Ladungszustand der Batterie darzustellen. Mit Hilfe dieser Sender- und Empfangseinheit 12 kann ein Bediener einen Defekt des Stellgliedes 7 und den Ladungszustand der Batterie 5 feststellen. Nach Weggang des Benutzers oder Bedieners werden wieder Detektionsimpulse ausgesendet.

Soll ein solches Gerät als Urinalwasserspülung eingesetzt werden, müssen die Steuerbefehle, die im Speicher 9 abgelegt sind, für das Stellglied 7 verändert werden. Dies wird mit Hilfe der Sender- und Empfangseinheit 12 bewerkstelligt. Über eine auf der Einheit 12 angeordnete Tastatur 17 können Steuerbefehle eingegeben werden, die von der Auswerte- und Steuerschaltung 15 in entsprechend codierte elektrische Impulse umgesetzt und als Infrarot-Steuerimpulse vom Infrarotsender 13 ausgesendet werden. Diese werden dann vom Infrarotempfänger 4 der Einheit 1 empfangen und mittels der Steuerschaltung 2 in den Speicher 9 geschrieben.

Des weiteren kann mittels der Sender- und Empfangseinheit 12 eine Einstellung der Sendeleistung des Infrarotsenders 3 und der Empfängerleistung des Infrarotempfängers 4 vorgenommen werden. Hierbei sendet die Einheit 12 Einstellimpulse aus, die vom Infrarotempfänger 4 empfangen, von der Steuerschaltung 2 verarbeitet werden und bewirken, daß der Infrarotsender 3 Testimpulse aussendet, die von einem vor dem Infrarotsender und dem Infrarotempfänger im gewünschten Abstand positionierten Reflektor reflektiert werden. Die Testimpulse bestehen aus kurzen Impulsen, die in sehr geringen Intervallen aufeinanderfolgen. Anhand der empfangenen reflektierten Testimpulse nimmt die Steuerschaltung eine Einstellung des Infrarotsenders 3 und des Infrarotempfängers 4 vor.

Anhand des in Fig. 2 dargestellten Blockschaltbildes werden im einzelnen die Ablaufschritte der Steuerschaltung 2 bei Einstellbetrieb, Programmierbetrieb und Spülbetrieb erläutert. Die rechteckigen Blöcke beziehen sich hierbei auf das Programm, das in der Steuerschaltung 2 durchgeführt wird, während sich die ovalen Blöcke auf Anordnungen außerhalb der Steuerschaltung 2 beziehen. Ein rechteckiger Block symbolisiert eine Funktion und ein Pfeil kennzeichnet Daten oder Informationen. Im Spülbetrieb, d.h. wenn bei Annäherung eines Benutzers ein Spülvorgang ausgelöst werden soll, wird von einer Zeitsteuerung 20 veranlaßt, daß ein Impulsgeber 21 Detektionsimpulse über den Infrarotsender 3 ausstrahlt. Die Detektionsimpulse werden dem Impulsgeber 21 von einer Impulstabellensteuerung 22 geliefert, die eine Impulstabelle 23 steuert, in der verschiedene von dem Infrarotsender 3 auszustrahlende Impulse abgespeichert sind.

Nach Empfang der reflektierten Detektionsimpulse in dem Infrarotempfänger 4 wird in einer Empfangsauswertung 24 ein Vergleich der ausgesendeten in der Impulstabellensteuerung 22 vorhandenen Detektionsimpulse mit den empfangenen Impulsen vorgenommen. Wird in der Empfangsauswertung 24 festgestellt, daß die Impulse übereinstimmen, wird eine Funktionsprüfung in der Funktionssteuerung 25 durchgeführt. Dabei wird zuerst die Batterietesteinheit 6 von einer Batterieteststeuerung 26 befragt, wie der Ladungszustand der Batterie 5 ist. Ist der Ladungszustand der Batterie so, daß ein Spülvorgang eingeleitet und auch abgeschlossen werden kann, gibt die Batterieteststeuerung 26 eine Stellgliedsteuerung 27 frei, welche die Prüf- und Ansteuereinheit 8 zur Prüfung der Funktionsfähigkeit des Stellgliedes 7 veranlaßt. Ist das Stellglied 7 nicht defekt, kann der Spülvorgang eingeleitet werden. Die Batterieteststeuerung 26 und die Stellgliedsteuerung 27 melden der Funktionssteuerung 25 den Ladungszustand der Batterie 6 und den Funktionszustand des Stellgliedes 7.

Die Funktionssteuerung 25 gibt die Information über den Ladungszustand der Batterie 5 und den Funktionszustand des Stellgliedes 7 an die Impulstabellensteuerung 22 weiter, die aus der Impulstabelle 23, die den Zuständen entsprechenden Impulse heraussucht. Anschließend meldet die Funktionssteuerung 25 an den Impulsgeber 21, daß der Batterietest und der Test des Stellgliedes 7 durchgeführt worden sind und veranlaßt den Impulsgeber 21, die Statusimpulse, welche die in der Impulstabellensteuerung 22 abgelegten Informationen über Batterie 5 und Stellglied 7 enthaltenen, über den Infrarotsender 3 auszusenden. Mittels der Zeitsteuerung 20 wird bewirkt, daß die Statusimpulse in bestimmten Intervallen ausgesendet werden. Der Funktionssteuerung 25 wird von dem Impulsgeber 21 gemeldet, wenn Statusimpulse ausgesendet werden. Die Funktionssteuerung 25 erhält von der Empfangsauswertung 24 die Meldung, wenn reflektierte Statusimpulse empfangen werden. Hierbei wird in der Empfangsauswertung 24 ein Vergleich zwischen den empfangenen Impulsen und den in der Impulstabellensteuerung 22 abgelegten Impulsen durchgeführt. Erhält der Funktionsgeber 25 nach einer vorgegebenen Zeit nicht die Meldung von der Empfangsauswertung 24, daß reflektierte Statusimpulse empfangen worden sind (Weggang des Benutzers), wirkt die Funktionssteuerung 25 auf die Impulstabellensteuerung 22 so ein, daß diese sich aus der Impulstabelle 23 wieder die Detektionsimpulse holt, welche von dem Impulsgeber 21 dann wieder ausgesendet werden.

Damit das Gerät 1 in den Programmierbetrieb wechselt, müssen von der Sender- und Empfangseinheit Steuerimpulse ausgesendet werden. In den Steuerimpulsen sind Programmierbefehle enthalten, die in der Steuerschaltung 2 ausgewertet werden und in einer Steuertabelle 30 abgelegt werden. Die Steuertabelle 30 und die Impulstabelle 23 sind Teilspeicher des Speichers 9. Die entsprechenden Steuerbefehle werden über die Tastatur 17 eingegeben und von der Auswerte- und Steuerschaltung 15 in Steuerimpulse umgesetzt.

Die von dem Infrarotempfänger 4 empfangenen Steuerimpulse werden in der Empfangsauswertung 24 detektiert und von einer Programmiersteuerung 31 ausgewertet. Während des Programmierbetriebes schaltet die Programmiersteuerung 31 die Zeitsteuerung 20 ab, so daß der Impulsgeber 21 keine Detektionsimpulse mehr aussenden kann. In der Programmiersteuerung 31 werden nach der Auswertung der Steuerimpulse die Steuerbefehle in der Steuertabelle 30 abgelegt. Beim Einschalten des Stellgliedes 7 wird nun nach den in der Steuertabelle 30 abgelegten Befehlen der Spülvorgang eingeleitet.

Auch der Testbetrieb wird von der Sender- und Empfangseinheit 12 ausgelöst. Den Testbetrieb lösen Einstellimpulse aus, die von der Einheit 12 dem Infrarotempfänger 4 gesendet werden, die in der Empfangsauswertung 24 erkannt werden und bewirken, daß die Teststeuerung 32 aufgerufen wird. Die Teststeuerung 32 schaltet die Zeitsteuerung 20 so um, daß diese in sehr viel kürzeren Abständen den Impulsgeber 21 veranlaßt, Detektionsimpulse als Testimpulse über den Infrarotsender 3 auszusenden. Ein vor dem Infrarotempfänger 4 und dem Infrarotsender 3 im gewünschten Abstand angeordneter Reflektor reflektiert die Testimpulse zum Infrarotempfänger 4. Anhand der empfangenen Testimpulse veranlaßt die Teststeuerung 32 eine Ansteuerschaltung 33 die optimale Leistung für den Sender 3 und Empfänger 4 bei dem gewählten Abstand einzustellen.

## Patentansprüche

1. Anordnung zur Steuerung und Fernsteuerung eines bei Annäherung bzw. Weggang eines Benutzers ein- bzw. abschaltbaren, batteriebetriebenen Gerätes (1), insbesondere einer Wasserspülung, mit einem bei Annäherung des Benutzers in Betrieb setzbaren elektrischen Stellglied (7),
einer Steuerschaltung (2), die einen Infrarotsender (3) zur Aussendung von Detektionsimpulsen ansteuert und die nach Empfang der von einem Benutzer reflektierten Detektionsimpulse in einem Infrarotempfänger (4) das Stellglied zur Einschaltung vorbereit,
und einer Testeinheit (6) zur Messung des Ladungszustandes der Batterie (5),
dadurch gekennzeichnet, daß nach Empfang der reflektierten Detektionsimpulse die Steuerschaltung (2)
- die Testeinheit (6) über den gemessenen Ladungszustand der Batterie (5) abfragt,
- das Stellglied (7) nur dann zur Einschaltung vorbereitet, wenn die Batterie einen solchen Ladungszustand aufweist, daß das Stellglied wieder abschaltbar ist und
- den Infrarotsender (3) anschließend veranlaßt, anstatt der Detektionsimpulse Statusimpulse auszusenden, welche eine Information über den Ladungszustand der Batterie enthalten und von einer zusätzlichen Infrarot-Empfangseinheit (12) empfangbar sind, die eine Auswerteschaltung (15) zur Auswertung der Statusimpulse und eine Anzeigevorrichtung (16) zur Anzeige des Ladungszustandes der Batterie enthält.

2. Anordnung nach Anspruch 1,
dadurch gekennzeichnet, daß nach Empfang der reflektierten Detektionsimpulse eine Prüfeinheit (8) den Zustand des Stellgliedes (7) bei Abfragung der Steuerschaltung (2) meldet und daß die Steuerschaltung den Statusimpulsen eine Zusatzinformation über den Zustand des Stellglieds dazugibt.

3. Anordnung nach Anspruch 1 oder 2,
dadurch gekennzeichnet, daß nach Empfang von Infrarot-Steuerimpulsen, die von einer zur Programmierung dienenden Infrarot-Sendereinheit (12) ausgegeben werden, die Steuerschaltung (2)
- den Infrarotsender (3) veranlaßt, keine Detektions- oder Statusimpulse auszusenden und
- einen Speicher (9) aufruft, in welchen die in den Steuerimpulsen vorhandene Information zur Steuerung des Stellgliedes (7) bei Inbetriebnahme abgelegt wird.

4. Anordnung nach Anspruch 3,
dadurch gekennzeichnet, daß nach Empfang von Infrarot-Einstellimpulsen, die von der Infrarot-Sendereinheit (12) ausgegeben werden, die Steuerschaltung (2)
- den Infrarotsender (3) veranlaßt, Infrarot-Testimpulse auszusenden, welche ein vor dem Infrarotsender und -empfänger (4) angeordneter Reflektor reflektiert, und
- durch Bestimmung der Stärke der reflektierten Testimpulse eine Einstellung der Leistung des Infrarotsenders und/oder Infrarotempfängers mittels einer Ansteuerschaltung (33) vornimmt.

## Claims

1. A device for control and remote control of a battery-powered apparatus (1) which can be switched on and off upon approach and withdrawal, respectively, of a user, more particularly a water-flushing system, comprising
- an electrical adjustment member (7) which can be activated when the user approaches,
- a control circuit (2) which activates an infrared transmitter (3) to transmit detection pulses and conditions the adjustment member for switching-on, after reception of the detection pulses reflected by a user in an infrared receiver (4), and
- a test unit (6) for measuring the charge of the battery (5),
characterized in that, after reception of the reflected detection pulses, the control circuit (2)
- interrogates the test unit (6) about the measured charge of the battery (5),
- conditions the adjustment member (7) for switching on only if the battery has such a charge that the adjustment member can be switched off again, and
- subsequently activates the infrared transmitter (3) to transmit status pulses instead of the detection pulses, which status pulses contain information about the charge of the battery and can be received by an additional infrared receiver unit (12) which comprises an evaluation circuit (15) for evaluating the status pulses and display device (16) for indicating the charge of the battery.

2. A device as claimed in Claim 1, characterized in that, after reception of the reflected detection pulses, a checking unit (8) informs, upon interrogation, the control circuit (2) about the state of the adjustment member (7) and the control circuit additionally inserts into the status pulses additional information about the state of the adjustment member.

3. A device as claimed in Claim 1 or 2, characterized in that, after reception of infrared control pulses, supplied by an infrared transmitter unit (12) serving for the programming, the control circuit (2)
- causes the infrared transmitter (3) to cease the transmission of detection or status pulses, and
- addresses a memory (9) storing the information present in the control pulses for controlling the adjustment member (7) when the apparatus is put into operation.

4. A device as claimed in Claim 3, characterized in that, after reception of infrared adjustment pulses, supplied by the infrared transmitter unit (12), the control circuit (2)
- causes the infrared transmitter (3) to transmit infrared test pulses which are reflected by a reflector arranged in front of the infrared transmitter and receiver (4), and
- adjusts the power of the infrared transmitter and/or the infrared receiver, using a control circuit (33), by determining the intensity of the reflected test pulses.

## Revendications

1. Dispositif de commande et de télécommande d'un appareil (1) alimenté par piles, mis en fonction et hors fonction par l'approche ou l'éloignement d'un utilisateur, en particulier pour un écoulement d'eau, comportant
un actionneur électrique (7) pouvant être activé par l'approche d'un utilisateur,
un circuit de commande (2) qui active un émetteur infrarouge (3) pour émettre des impulsions de détection et qui, après réception, dans un récepteur infrarouge (4), des impulsions de détection réfléchies par un utilisateur, prépare l'actionneur pour la mise en fonction, et
une unité de test (6) pour mesurer l'état de charge de la pile (5),
caractérisé en qu'après la réception des impulsions de détection réfléchies, le circuit de commande (2)
- interroge l'unité de test (6) au sujet de l'état de charge mesuré de la pile (5),
- ne prépare l'actionneur (7) pour la mise en fonction que lorsque la pile présente un état de charge tel que l'actionneur puisse être remis hors fonction, et
- amène ensuite l'émetteur infrarouge (3) à émettre, en lieu et place des impulsions de détection, des impulsions d'état qui contiennent une information au sujet de l'état de charge de la pile et peuvent être reçues par une unité de réception infrarouge supplémentaire (12) qui contient un circuit d'évaluation (15) pour évaluer les impulsions d'état et un dispositif d'affichage (16) pour afficher l'état de charge de la pile.

2. Dispositif suivant la revendication 1, caractérisé en ce qu'après la réception des impulsions de détection réfléchies, une unité de contrôle (8) indique l'état de l'actionneur (7) lors de l'interrogation par le circuit de commande (2) et que le circuit de commande ajoute aux impulsions d'état une information supplémentaire portant sur l'état de l'actionneur.

3. Dispositif suivant la revendication 1 ou 2 caractérisé en ce qu'après la réception d'impulsions de commande infrarouges qui sont émises par une unité d'émission infrarouge (12) servant à la programmation, le circuit de commande (2)
- amène l'émetteur infrarouge (3) à n'émettre aucune impulsion de détection ou d'état, et
- appelle une mémoire (9) dans laquelle est archivée l'information présente dans les impulsions de commande pour la commande de l'actionneur (7) lors de la mise en fonction.

4. Dispositif suivant la revendication 3, caractérisé en ce qu'après la réception d'impulsions de réglage infrarouges qui sont émises par l'unité d'émission infrarouge (12), le circuit de commande (2)
- amène l'émetteur infrarouge (3) à émettre des impulsions de test infrarouges qui sont réfléchies par un réflecteur installé devant l'émetteur et le récepteur infrarouge (4), et
- par détermination de l'intensité des impulsions de test réfléchies, procède à un réglage de la puissance de l'émetteur infrarouge et/ou du récepteur infrarouge au moyen d'un circuit d'asservissement (33).
